(19) Europäisches Patentamt / European Patent Office / Office européen des brevets

(11) **EP 3 011 399 B1**

(12) **FASCICULE DE BREVET EUROPEEN**

(45) Date de publication et mention
de la délivrance du brevet:
**04.10.2017 Bulletin 2017/40**

(21) Numéro de dépôt: **14736891.4**

(22) Date de dépôt: **11.06.2014**

(51) Int Cl.:
*G06F 9/445* (2006.01)   *G06F 17/50* (2006.01)
*G05B 17/02* (2006.01)

(86) Numéro de dépôt international:
**PCT/FR2014/051409**

(87) Numéro de publication internationale:
**WO 2014/202867 (24.12.2014 Gazette 2014/52)**

(54) **PROCÉDÉ ET SYSTÈME DE RECALAGE D'UN MODÈLE NUMÉRIQUE**

VERFAHREN UND SYSTEM ZUR RÜCKSTELLUNG EINES DIGITALEN MODELLS

METHOD AND SYSTEM FOR RESETTING A DIGITAL MODEL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **18.06.2013 FR 1355712**

(43) Date de publication de la demande:
**27.04.2016 Bulletin 2016/17**

(73) Titulaire: **SNECMA**
**75015 Paris (FR)**

(72) Inventeur: **DJELASSI, Cedrik**
**F-77550 Moissy-Cramayel Cedex (FR)**

(74) Mandataire: **Delumeau, François Guy et al
Cabinet Beau de Loménie
158, rue de l'Université
75340 Paris Cedex 07 (FR)**

(56) Documents cités:
**WO-A1-2010/067009    US-A- 5 080 496
US-A1- 2012 283 849**

**Description**

<u>Arrière-plan de l'invention</u>

L'invention se rapporte au domaine général de l'amélioration des performances des systèmes dont le fonctionnement repose sur l'utilisation d'un modèle numérique dont au moins un paramètre dépend d'une mesure réalisée par un capteur.

Il est en effet fréquent que des capteurs souffrent, lors d'une mesure, d'une certaine inertie, propre à chaque capteur et qui dépend, notamment de la masse ou de la taille de ce capteur. Cette inertie se traduit par un décalage temporel entre le moment où la mesure est réalisée par le capteur et le moment où celui-ci délivre un signal en réponse à cette mesure. On parle aussi « d'effet de traînage ».

Pour pallier cet inconvénient, il est connu de modéliser l'inertie du capteur à l'aide d'un filtre paramétré par une constante de temps modélisant le temps de réponse du capteur, autrement dit son inertie.

Ces méthodes, notamment décrites dans le document US 5,080,496 utilisent des abaques figés et s'appliquent difficilement notamment lorsque la constante de temps du capteur dépend de son environnement d'utilisation ou lorsque la constante de temps du capteur est susceptible de varier fortement d'un capteur à l'autre.

Le document WO 2010/067009 présente un procédé de correction d'un signal de mesure délivré par un capteur de température permettant une compensation de l'effet de traînage introduit par ce capteur, quelle que soit la constante de temps de ce capteur.

Cette méthode utilise un modèle numérique de la température mesurée par le capteur. Cependant, des erreurs sur ce modèle peuvent conduire à une sur-estimation ou une sous-estimation de l'évolution de la température pendant le transitoire mécanique, jusqu'à ce que la mesure de température converge et se stabilise.

L'invention vise notamment à pallier cet inconvénient.

<u>Objet et résumé de l'invention</u>

La présente invention répond à ce besoin en proposant un procédé de recalage d'un modèle numérique de base, ce procédé comportant :

- une étape de détection d'un état stable d'au moins un premier paramètre de ce modèle, ce premier paramètre étant représentatif d'un signal délivré par un capteur ;
- une étape d'obtention d'un paramètre de recalage de ce modèle, pendant l'état stable du premier paramètre, en fonction du premier paramètre, d'un deuxième paramètre du modèle, et du modèle numérique de base ; et
- une étape d'obtention d'un modèle recalé à partir du modèle numérique de base et du paramètre de recalage.

Ainsi, et d'une façon générale, l'invention propose une solution autonome pour recaler automatiquement un modèle numérique sur la mesure du signal délivré par le capteur lorsque celle-ci est stabilisée et ne subit donc plus d'erreur liée à son traînage.

Dans un mode particulier de réalisation, le procédé de recalage selon l'invention comporte :

- une étape préliminaire de partitionnement du domaine des valeurs possibles du deuxième paramètre en une pluralité de plages ;
- une étape de détermination et de mémorisation de la plage dans laquelle se trouve le deuxième paramètre pendant l'état stable du premier paramètre ;
- une étape de calcul ou d'estimation d'une valeur locale de recalage et d'attribution de cette valeur locale à au moins une de ces plages ;
- ledit paramètre de recalage étant obtenu à partir des valeurs locales de recalage et de la valeur courante dudit deuxième paramètre.

Ce mode particulier de réalisation permet avantageusement de discrétiser le modèle numérique de base en fonction du deuxième paramètre en attribuant à chacune des plages définies par ces valeurs discrètes une valeur unique de recalage pour l'ensemble de la plage.

Dans un mode particulier de réalisation de l'invention, la valeur locale de recalage attribuée à l'une des plages est une valeur attribuée à une autre plage, cette autre plage étant déterminée à partir d'une table de vérité.

Ce mode particulier de réalisation permet de pallier à la situation dans laquelle les valeurs locales de recalage n'ont pas été attribuées à toutes les plages.

Dans un mode particulier de réalisation, le procédé selon l'invention, comporte, pour au moins une partie du domaine des valeurs possibles du deuxième paramètre, une étape d'interpolation du paramètre de recalage à partir d'au moins une des valeurs locales de recalage.

Dans ce mode de réalisation, la précision de l'interpolation peut être facilement améliorée en augmentant le nombre de plages précitées.

Dans un mode particulier de réalisation, le procédé de recalage selon l'invention est mis en oeuvre dans un turboréacteur une fois et une seule par vol et il comporte après la détermination de la plage dans laquelle se trouve le deuxième paramètre, une étape de mémorisation, dans une mémoire non volatile associée à cette plage, du deuxième paramètre et de la valeur locale de recalage.

Ce mode de réalisation permet le recalage automatique du modèle de façon suffisamment fréquente pour corriger le modèle des effets liés aux dérives dans le temps notamment dans le cas du vieillissement du turboréacteur.

Le fait de mémoriser les gains d'un vol à l'autre permet de garantir une compensation optimisée dès le premier transitoire.

Dans un mode particulier de réalisation, le modèle est une loi de gain donnant le rapport entre deux températures à deux étages différents du turboréacteur en fonction d'une vitesse de rotation d'une soufflante du turboréacteur, le premier paramètre est l'une desdites températures et le deuxième paramètre étant ladite vitesse de rotation.

La présente invention, peut, dans ce mode de réalisation, perfectionner la méthode décrite dans le document WO 2010/067009.

Dans un mode particulier de réalisation, le procédé de recalage selon l'invention comporte une étape de calcul d'une valeur corrigée du premier paramètre à partir de la valeur courante du premier paramètre et du modèle recalé.

Dans un mode particulier de réalisation, l'étape de mémorisation de la plage dans laquelle se trouve le deuxième paramètre est effectuée sous condition du résultat positif d'une étape de vérification de l'état démarré d'un moteur du turboréacteur. Cela permet de s'assurer de la précision de la mesure.

Dans un mode particulier de réalisation, le procédé de recalage selon l'invention comporte une étape de lissage du paramètre de recalage.

Corrélativement, l'invention vise un système de recalage d'un modèle numérique de base, ce système comportant :

- un module de détection d'un état stable d'au moins un premier paramètre du modèle, ce premier paramètre étant représentatif d'un signal délivré par un capteur ;
- un module d'obtention d'un paramètre de recalage du modèle, pendant l'état stable du premier paramètre, en fonction du premier paramètre, d'un deuxième paramètre du modèle, et du modèle numérique de base ; et
- un module d'obtention d'un modèle recalé à partir du modèle numérique de base et du paramètre de recalage.

Comme mentionné précédemment, du fait de ses caractéristiques et avantages précités, l'invention a une application privilégiée mais non limitative dans le domaine de l'aéronautique et plus particulièrement dans le domaine de la régulation et du pilotage de moteurs d'aéronef.

Ainsi, l'invention vise aussi un turboréacteur comportant un système de recalage d'un modèle numérique de base conforme à l'invention.

L'invention vise aussi une utilisation d'un procédé de recalage comme mentionné ci-dessus, dans lequel on utilise, pour réguler le turboréacteur, le premier paramètre du modèle recalé, à la place du premier paramètre représentatif du signal délivré par le capteur, ce signal délivré par ledit capteur n'étant utilisé que pour recaler le modèle de base et obtenir le modèle recalé.

Brève description des dessins

D'autres caractéristiques et avantages de la présente invention ressortiront de la description faite ci-dessous, en référence aux dessins annexés qui en illustrent un exemple dépourvu de tout caractère limitatif.

Sur les figures :

- la figure 1 représente de façon schématique un modèle numérique pouvant être recalé par un système et un procédé conformes à l'invention ;
- la figure 2 représente, de façon schématique, un système de recalage conforme à un mode particulier de réalisation de l'invention ;
- la figure 3 représente, sous forme d'organigramme, les principales étapes d'un procédé de recalage conforme à un mode particulier de réalisation de l'invention ;
- la figure 4 représente, de façon schématique, un module de détection d'un état stable, pouvant être utilisé dans le système de la figure 2 ;
- la figure 5 représente, de façon schématique, un module pouvant être utilisé dans le système de la figure 2 pour détecter et mémoriser une plage du deuxième paramètre ; ;

- la figure 6 représente une table de vérité pouvant être utilisée dans le système de la figure 2 ;
- la figure 7 représente, de façon schématique, un module pouvant être utilisé dans le système de la figure 2 pour mémoriser des valeurs locales de recalage ;
- la figure 8 représente le résultat d'une étape d'interpolation d'un mode particulier de réalisation d'un procédé conforme à l'invention ;
- la figure 9 représente, de façon schématique, un module de sélection d'un paramètre de recalage pouvant être utilisé dans le système de la figure 2.

Description détaillée d'un mode de réalisation

Nous allons maintenant décrire un système et un procédé de recalage d'un modèle numérique de base, conformément à un mode particulier de réalisation de l'invention.

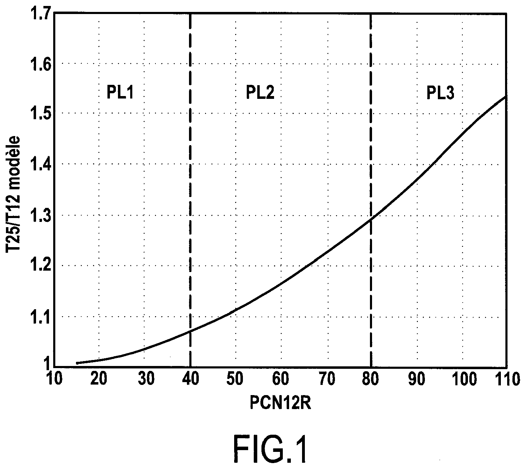

Dans l'exemple décrit ici, le modèle numérique de base que l'on cherche à recaler est celui d'une loi de gain permettant la correction d'un signal de mesure T25 délivré par un capteur présentant une inertie thermique et utilisé pour la régulation d'un turboréacteur d'un avion. Plus précisément, en référence à la figure 1, ce modèle permet d'estimer un rapport de températures T25/T12 en fonction de la vitesse PCN12R de rotation d'une soufflante de ce turboréacteur, T12 représentant la température à l'entrée de la soufflante et T25 la température en entrée du compresseur haute-pression du turboréacteur.

Dans l'exemple de réalisation décrit ici, on partitionne le domaine des valeurs possibles de la vitesse PCN12R (deuxième paramètre au sens de l'invention) en trois plages PL1, PL2, PL3. Ce choix de trois plages n'est pas limitatif, l'invention pouvant s'appliquer à un nombre quelconque de plages.

Dans l'exemple de réalisation décrit ici, les trois plages PL1, PL2, PL3 de la vitesse de rotation PCN12R sont les plages [0 ; 40], [40 ; 80], [80, ...].

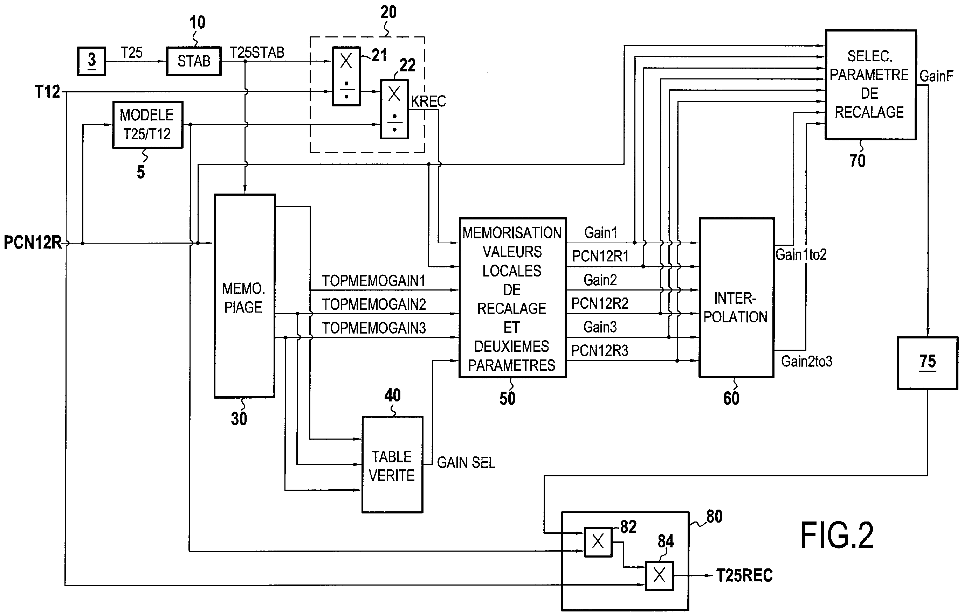

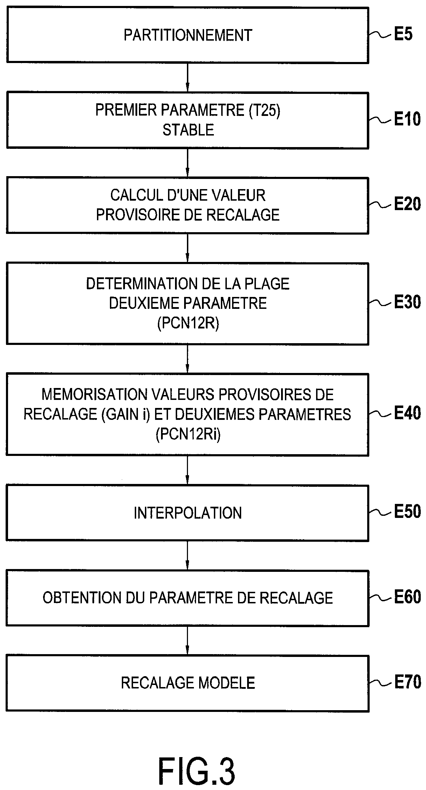

Les figures 2 et 3 représentent respectivement un système de recalage et un procédé de recalage aptes à recaler le modèle numérique de base de la figure 1.

L'étape E5 de partitionnement du domaine des valeurs possibles de la vitesse de rotation de la soufflante (deuxième paramètre au sens de l'invention) est une étape préliminaire pouvant être effectuée lors d'une phase de test, cette étape consistant principalement à choisir le nombre approprié de plages et les bornes de ces plages.

Dans ce mode de réalisation de l'invention, le système 1 comporte notamment :

- un capteur 3 de la température T25 ;
- un module 10 de détection d'un état stable d'une mesure du signal délivré par ce capteur (premier paramètre au sens de l'invention) ;
- un module 20 de calcul d'une valeur locale de recalage ;
- un module 30 pour déterminer et mémoriser la plage dans laquelle se trouve le deuxième paramètre (vitesse de rotation de la soufflante) pendant l'état stabilisé du premier paramètre (température T25) ;
- une table de vérité 40 ;
- un module 50 de mémorisation d'une valeur locale de recalage et de la valeur courante du deuxième paramètre pour chacune des plages ;
- un module 60 d'interpolation des valeurs locales de recalage ;
- un module 70 de sélection du paramètre de recalage à partir des valeurs locales de recalage et de la valeur courante du deuxième paramètre ; et
- un module 80 de correction du modèle de base en fonction du paramètre de recalage.

De façon corollaire, les principales étapes du procédé de recalage de la figure 3 sont :

- une étape E5 préliminaire de partitionnement du domaine des valeurs possibles du deuxième paramètre ;
- une étape E10 de détection d'un état stable de la température T25 (premier paramètre au sens de l'invention) ;
- une étape E20 de calcul d'une valeur locale de recalage ;
- une étape E30 de détermination et de mémorisation de la plage dans laquelle se trouve le deuxième paramètre pendant l'état stabilisé du premier paramètre.
- une étape E40 de mémorisation de la valeur locale de recalage et de la valeur courante du deuxième paramètre pour chacune des plages ;
- une étape E50 d'interpolation des valeurs locales de recalage ;
- une étape E60 d'obtention du paramètre de recalage à partir des valeurs locales de recalage et de la valeur courante du deuxième paramètre ;
- une étape E70 d'obtention du modèle recalé à partir du modèle numérique de base et du paramètre de recalage.

Dans la suite de la description, on considère des signaux et des paramètres échantillonnés à une période d'échantillonnage *Te.* Cette période d'échantillonnage est par exemple de l'ordre de 20 à 40 ms.

On notera cependant que l'invention peut également être mise en oeuvre avec des signaux et des paramètres continus.

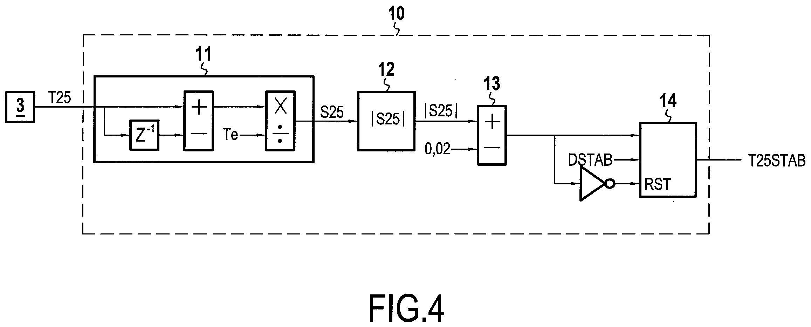

La figure 4 représente un mode de réalisation particulier du module 10 de détection d'un état stable du premier paramètre.

Dans l'exemple décrit ici, le module 10 reçoit en entrée le signal de mesure T25 délivré par le capteur 3 et fournit en sortie un signal T25STAB dès lors que la mesure est dans un état stable depuis au moins une durée prédéterminée de stabilisation DSTAB, par exemple de l'ordre de 5s.

Dans le mode particulier de réalisation décrit ici, ce module 10 comporte:

- un module dérivateur 11 qui reçoit en entrée le signal de mesure T25 et fournit en sortie un signal S25 obtenu par dérivation du signal de mesure T25. Dans le mode de réalisation décrit ici, le module dérivateur 11 comporte une cellule de retard délivrant le signal de mesure T25 à l'instant *(n-1).Te,* un élément soustracteur permettant de soustraire au signal de mesure T25[*nTe*], le signal de mesure retardé T25[*(n-1).Te*] et un élément diviseur adapté à diviser la somme ainsi obtenue par la période d'échantillonnage Te. Dans ce mode de réalisation, le module dérivateur 11 est un filtre d'ordre 1. En variante, le module dérivateur 11 peut être un filtre d'ordre supérieur ;
- un module de calcul 12 apte à évaluer la valeur absolue |S25| du signal dérivé S25 ;
- un module comparateur 13 apte à comparer la valeur absolue |S25| avec un seuil proche de 0, par exemple 0.02 afin de détecter une phase de stabilité de la mesure ; et
- un compteur 14 de la durée prédéterminée de stabilisation DSTAB, réinitialisé dès lors que la mesure n'est pas dans une phase de stabilité.

De retour à la figure 3, le système 1 selon l'invention comporte un module 20 de calcul d'une valeur locale de recalage KREC. Dans le mode de réalisation décrit ici, ce module comporte :

- un premier diviseur 21 apte à évaluer le rapport T25/T12, lorsque la température T25 en entrée du compresseur haute pression est stabilisée ; et
- un deuxième diviseur 22 apte à déterminer la valeur locale de recalage KREC à partir de ce rapport T25/T12 et d'un module 5 implémentant le modèle de base décrit précédemment en référence à la figure 1.

Dans le mode de réalisation décrit ici, le système et le procédé de recalage selon l'invention associe cette valeur locale de recalage KREC Gain1, Gain2, Gain3 à au moins une des plages PL1, PL2, PL3 définies pendant l'étape préliminaire de partitionnement. La valeur locale de recalage, lorsqu'elle est associée à la plage PLi est aussi référencée Gaini.

A cet effet, le procédé selon l'invention comporte une étape E30 de détermination et de mémorisation de la plage dans laquelle se trouve le deuxième paramètre pendant l'état stabilisé du premier paramètre.

De façon corollaire, le système 1 comporte un module 30 pour déterminer et mémoriser la plage dans laquelle se trouve le deuxième paramètre pendant l'état stabilisé du premier paramètre.

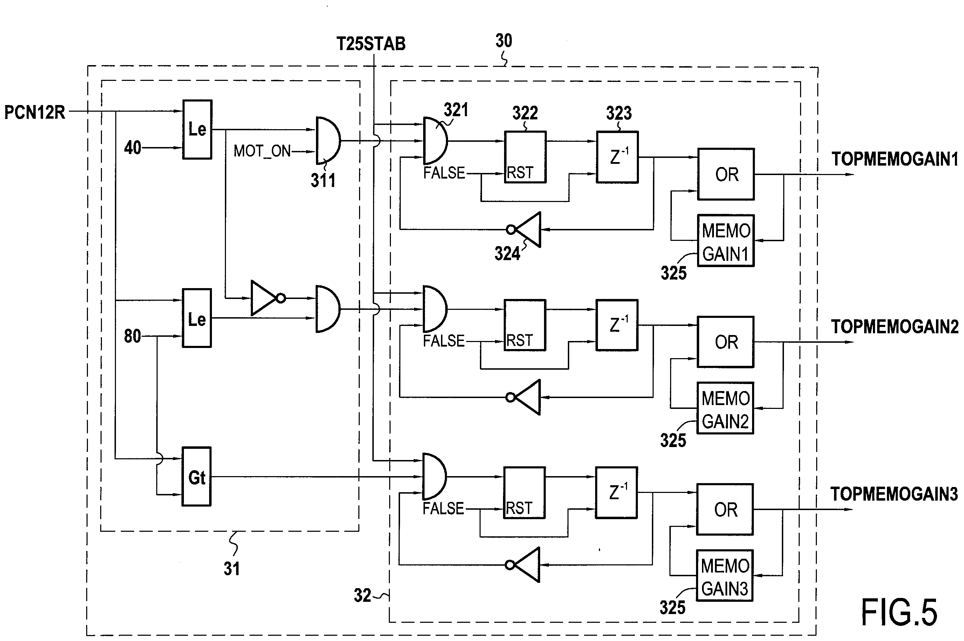

Un mode particulier de réalisation de ce module 30 est représenté à la figure 5.

Dans l'exemple décrit ici, le module 30 reçoit en entrée un signal PCN12R représentatif de la vitesse de rotation de la soufflante (deuxième paramètre au sens de l'invention), identifie une plage de gain conformément au modèle de la figure 1 et mémorise cette information dans une mémoire non volatile 325.

Plus précisément, le module 30 comporte un premier étage 31 permettant de déterminer la plage dans laquelle se situe la vitesse PCN12R de rotation de la soufflante, parmi les plages PL1 à PL3 ([0 ; 40], [40 ; 80], [80, ...]) et un deuxième étage 32 permettant de mémoriser, dans la mémoire non volatile 325, une information selon laquelle un couple (valeur locale de recalage, vitesse de rotation de la soufflante) a été mémorisé pour cette plage.

De façon remarquable, dans ce mode de réalisation la première porte ET du premier étage 31 prend en entrée un signal MOT_ON, la valeur VRAI de ce signal étant représentative du fait qu'un moteur du turboréacteur a démarré. Cette condition supplémentaire pour mémoriser la plage de gain est vérifiée à l'étape E25 du procédé selon l'invention. En variante d'autres conditions pourraient être prises en compte.

Dans le mode de réalisation décrit ici, la phase d'identification de la plage de gain est effectuée à chaque cycle de vol, une seule fois par cycle de vol. Cette caractéristique, qui permet de rendre plus robuste le recalage, est implémentée, dans le mode de réalisation de la figure 5, en intercalant un inverseur 324 entre la sortie du retardateur 323 et une entrée de la porte logique ET 321.

Dans le mode de réalisation décrit ici, la mémorisation est réinitialisée à chaque arrêt moteur par le module 322 initialisé à FAUX (FALSE).

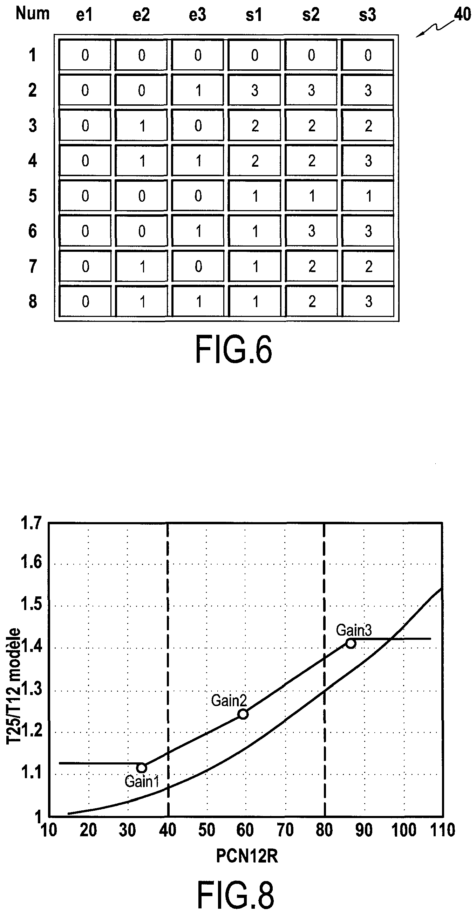

Dans le mode de réalisation décrit ici, le système 1 selon l'invention comporte une table de vérité 40 représentée à la figure 6. Cette table de vérité permet d'attribuer une valeur locale de recalage KREC à une plage non encore identifiée.

Par exemple, la ligne 6 représente la situation dans laquelle des valeurs locales de recalage Gain1 et Gain3 ont été attribuées aux plages PL1 et PL3 suite à la détection d'une vitesse de rotation de la soufflante dans chacune de ces plages, aucune valeur locale n'ayant été attribuée dans à la plage PL2. Dans ce cas, on attribue le gain Gain3 à la plage PL2 (Gain2 = Gain3). Le fonctionnement normal est celui dans lequel une valeur locale de recalage a été identifiée pour chaque des plages (table de vérité 40, ligne 8).

Le procédé selon l'invention comporte une étape E40 de mémorisation de la valeur locale de recalage $Gain_i$ et de la valeur du deuxième paramètre (noté $PCN12R_i$) pour chacune des plages $PL_i$.

De façon corollaire, le système 1 selon l'invention comporte un module 50 de mémorisation de la valeur locale de recalage $Gain_i$ et de la valeur du deuxième paramètre (noté $PCN12R_i$) pour chacune des plages $PL_i$.

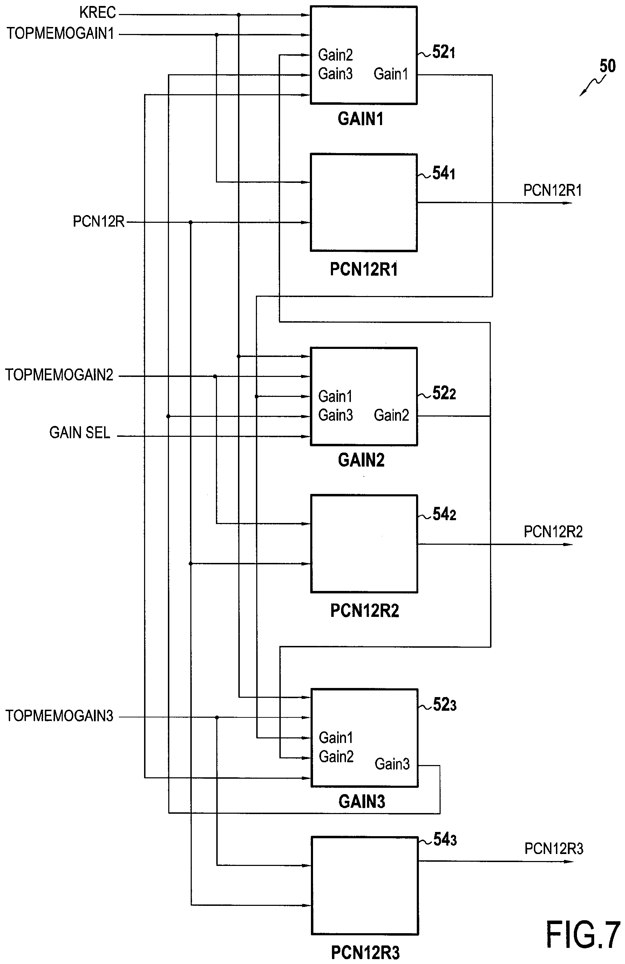

La figure 7 représente un exemple d'implémentation de ce module. Dans cet exemple, pour chacune des plages PLi ([0 ; 40], [40 ; 80], [80, ...]), on utilise un module 52i de mémorisation de la valeur locale de recalage ($Gain_i$) et un module 54i de mémorisation du deuxième paramètre (vitesse de rotation de la soufflante $PCN12R_i$). Seuls ceux relatifs à la première plage PL1 seront décrits.

Le module $52_1$ de mémorisation du gain Gain1 et le module $54_1$ de mémorisation de la vitesse de rotation de la soufflante PCN12R1 reçoivent en entrée le signal TOPMEMOGAIN1 représentatif du fait qu'une vitesse de rotation de la soufflante PCN12R comprise dans la plage PL1 ([0 ; 40]) a été détectée par le module 40, les autres conditions de mémorisation (température T25 stabilisée, moteur du turboréacteur démarré, ...) étant satisfaites.

Dans ces conditions, la valeur locale de recalage KREC calculée par le module 20 est attribuée à la plage PL1 (et donc renommée Gain1) et mémorisée dans le module $52_1$. De même, la vitesse de rotation PCN12R est attribuée à la plage PL1 (et donc renommée PCN12R1) et mémorisée dans le module $54_1$.

Comme mentionné précédemment, la table de vérité 40 permet d'assigner la valeur d'un autre gain Gain2 ou Gain3 au Gain1 lorsque celui-ci n'a pas été déterminé. A cet effet, les sorties Gain2 et Gain3 des modules $52_{2,3}$ de mémorisation des gains Gain2 et Gain3 sont redirigées vers l'entrée du module 52 de mémorisation du gain Gain1.

A ce stade du procédé, on a donc obtenu une valeur locale de recalage ($Gain_i$) pour chacune des plages, associée à une valeur du deuxième paramètre ($PCN12R_i$, vitesse de rotation de la soufflante).

Dans le mode de réalisation décrit ici, le procédé selon l'invention comporte, pour au moins une partie du domaine des valeurs possibles du deuxième paramètre PCN12R, une étape E50 d'interpolation du paramètre de recalage à partir d'une ou plusieurs valeurs locales de recalage.

De la même façon, dans le mode de réalisation décrit ici, le système 1 selon l'invention comporte un module 60 d'obtention du paramètre de recalage par interpolation des valeurs locales de recalage. Dans l'exemple décrit ici, on applique plus précisément une interpolation linéaire entre Gain1 et Gain2 si PCN12R est compris entre PCN12R1 et PCN12R2 et une interpolation linéaire entre Gain2 et Gain3 si PCN12R est compris entre PCN12R2 et PCN12R3.

On obtient :

$$Gain1to2 = Gain1 + (Gain2\text{-}Gain1).(PCN12R\text{-}PCN12R1)/(PCN12R2\text{–}PCN12R1).$$

$$Gain2to3 = Gain2 + (Gain3\text{-}Gain2).(PCN12R\text{-}PCN12R2)/(PCN12R3\text{–}PCN12R2).$$

La figure 8 représente le résultat de l'étape E50 d'interpolation d'un mode particulier de réalisation d'un procédé conforme à l'invention. Dans ce mode de réalisation particulier, on utilise en outre Gain1 pour toute vitesse de rotation de la soufflante inférieure à PCN12R1 et Gain3 pour toute vitesse de rotation de la soufflante supérieure à PCN12R3.

Le paramètre de recalage GainF est obtenu (étape E60) à partir des valeurs locales de recalage Gain1, Gain2, Gain3 en fonction de la valeur courante du deuxième paramètre (vitesse de rotation de la soufflante) PCN12R.

De façon corollaire, dans le mode de réalisation décrit ici, le système 1 selon l'invention comporte un module 70 de sélection du paramètre de recalage à partir des valeurs locales de recalage en fonction de la valeur courante du deuxième paramètre PCN12R.

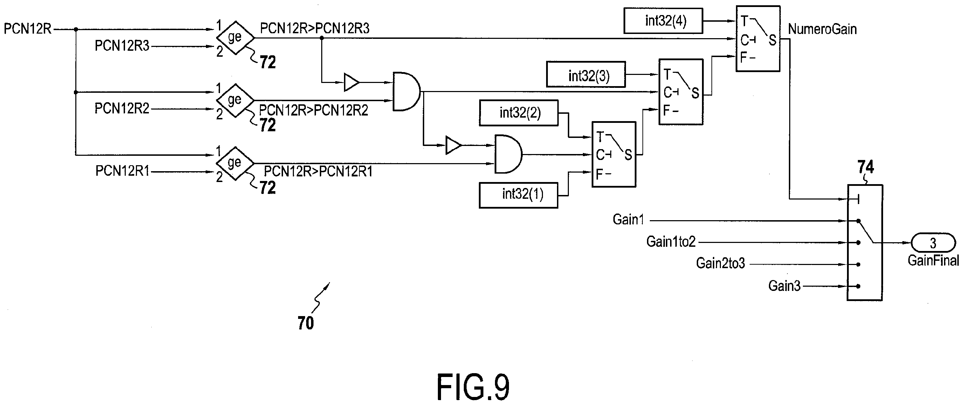

La figure 9 représente un mode de réalisation particulier du module 70 de sélection du gain final GainF. Ce module comporte trois comparateurs 72 aptes à comparer la vitesse de rotation de la soufflante PCN12R avec les valeurs PCN12R1, PCN12R2 et PCN12R3 correspondant aux trois plages de gains et mémorisées par le module 50.

Un numéro de gain NumeroGain est alors attribué en fonction du résultat de ces comparaisons.

- NumeroGain = 4 si PCN12R > PCN12R3
- NumeroGain = 3 si PCN12R3 > PCN12R > PCN12R2
- NumeroGain = 2 si PCN12R2 > PCN12R > PCN12R1

- NumeroGain = 1 si PCN12R1 > PCN12R

Le module 70 de sélection de gain comporte enfin un comparateur 74 apte à affecter au gain final GainF la valeur Gain1, Gain1to2, Gain2to3 ou Gain3 en fonction du numéro de gain NumeroGain.

Le procédé de recalage selon l'invention comporte une étape E70 d'obtention d'un modèle recalé à partir du modèle numérique de base 5 et du paramètre de recalage GainF.

De façon corollaire, le système 1 selon l'invention comporte un module 80 de correction du modèle de base 5 en fonction du gain final GainF. Dans ce mode de réalisation, ce module est constitué principalement par un multiplicateur 82.

Dans le mode de réalisation décrit ici, ce module 80 effectue en outre le recalage de la température T25 à partir de la température T12 courante et du modèle recalé (multiplicateur 84). On obtient ainsi un modèle recalé T25REC de la température T25.

Le modèle recalé T25REC de température est précis et peut, dans un mode particulier d'utilisation de l'invention, être utilisé à la place de la température T25 mesurée par le capteur. Dans ce mode de réalisation, le capteur 3 n'est finalement utilisé que pendant les phases stabilisées pour recaler le modèle.

Dans le mode de réalisation décrit ici, le système 1 selon l'invention comporte un limiteur de gradient, intercalé entre la sortie du module de sélection de gain 70 et l'entrée du module 80 de correction du modèle de base de manière à lisser le passage d'un gain à un autre.

Dans le mode de réalisation décrit précédemment, le modèle de base représenté à la figure 1 est un modèle uni-dimensionnel. L'invention s'applique de la même façon dans le cas d'un modèle à plusieurs dimensions.

**Revendications**

1. Procédé de recalage d'un modèle numérique de base (5) comportant :

   - une étape (E10) de détection d'un état stable d'au moins un premier paramètre (T25) dudit modèle, ce premier paramètre étant représentatif d'un signal délivré par un capteur (3) ;
   - une étape (E60) d'obtention d'un paramètre de recalage (GainF) dudit modèle, pendant ledit état stable dudit premier paramètre (T25), en fonction dudit premier paramètre, d'un deuxième paramètre (PCN12R) dudit modèle, et dudit modèle numérique de base (5) ; et
   - une étape (E70) d'obtention d'un modèle recalé à partir du modèle numérique de base (5) et du paramètre de recalage (GainF).

2. Procédé de recalage selon la revendication 1, **caractérisé en ce qu'**il comporte :

   - une étape (E5) préliminaire de partitionnement du domaine des valeurs possibles dudit deuxième paramètre (PCN12R) en une pluralité de plages ;
   - une étape (E30) de détermination et de mémorisation de la plage dans laquelle se trouve le deuxième paramètre (PCN12R) pendant l'état stabilisé du premier paramètre (T25) ;
   - une étape (E20) de calcul ou d'estimation (E25) d'une valeur locale de recalage (KREC) et d'attribution (E40) de ladite valeur locale (Gain1, Gain2, Gain3) à au moins une des dites plages (PL1, PL2, PL3) ;
   - ledit paramètre de recalage (GainF) étant obtenu (E60) à partir desdites valeurs locales de recalage (Gain1, Gain2, Gain3) et de la valeur courante dudit deuxième paramètre (PCN12R).

3. Procédé selon la revendication 2 **caractérisé en ce que** ladite valeur locale de recalage (Gain1) attribuée à l'une desdites plages (PL1) est une valeur attribuée (Gain2) à une autre desdites plages (PL2), cette autre plage étant déterminée à partir d'une table de vérité (40).

4. Procédé selon la revendication 2 ou 3 **caractérisé en ce qu'**il comporte, pour au moins une partie dudit domaine de valeurs, une étape (E50) d'interpolation dudit paramètre de recalage (Gain1to2) à partir d'au moins une desdites valeurs locales de recalage (Gain1, Gain2).

5. Procédé de recalage selon l'une quelconque des revendications 2 à 4, ledit procédé étant mis en oeuvre dans un turboréacteur une fois et une seule par vol, et **caractérisé en ce qu'**il comporte, après ladite détermination de la plage dans laquelle se trouve le deuxième paramètre (PCN12R), une étape de mémorisation, dans une mémoire non volatile associée à ladite plage, dudit deuxième paramètre et de ladite valeur locale de recalage.

**6.** Procédé de recalage selon la revendication 5 dans lequel :

- ledit modèle est une loi de gain donnant le rapport entre deux températures (T25, T12) à deux étages différents du turboréacteur en fonction d'une vitesse de rotation (PCN12R) d'une soufflante dudit turboréacteur ;
- ledit premier paramètre (T25) étant l'une desdites températures ;
- ledit deuxième paramètre étant ladite vitesse de rotation (PCN12R).

**7.** Procédé de recalage selon la revendication 6 **caractérisé en ce qu'**il comporte une étape de calcul d'une valeur corrigée (T25REC) dudit premier paramètre à partir de la valeur courante du premier paramètre (T25) et du modèle recalé.

**8.** Procédé de recalage selon l'une quelconque des revendications 5 à 7, **caractérisé en ce que** ladite étape de mémorisation de la plage dans laquelle se trouve le deuxième paramètre (PCN12R) est effectuée sous condition du résultat positif d'une étape (E25) de vérification de l'état démarré d'un moteur du turboréacteur.

**9.** Procédé de recalage selon l'une quelconque des revendications 5 à 8, **caractérisé en ce qu'**il comporte une étape de lissage du paramètre de recalage (GainF).

**10.** Système de recalage (1) d'un modèle numérique de base (5) comportant :

- un module (10) de détection d'un état stable d'au moins un premier paramètre (T25) dudit modèle, ce premier paramètre étant représentatif d'un signal délivré par un capteur (3) ;
- un module (70) d'obtention d'un paramètre de recalage (KREC) dudit modèle, pendant ledit état stable dudit premier paramètre (T25), en fonction dudit premier paramètre, d'un deuxième paramètre (PCN12R) dudit modèle, et dudit modèle numérique de base (5) ; et
- un module (80) d'obtention d'un modèle recalé à partir du modèle numérique de base (5) et du paramètre de recalage (GainF).

**11.** Turboréacteur **caractérisé en ce qu'**il comporte un système de recalage d'un modèle numérique de base selon la revendication 10.

**12.** Utilisation d'un procédé de recalage selon l'une quelconque des revendications 5 à 9, dans lequel on utilise, pour réguler ledit turboréacteur, ledit premier paramètre (T25REC) du modèle recalé, à la place du premier paramètre (T25) représentatif du signal délivré par le capteur (3), ce signal délivré par ledit capteur n'étant utilisé que pour recaler ledit modèle de base et obtenir ledit modèle recalé.

**Patentansprüche**

**1.** Verfahren zur Rückstellung eines numerischen Grundmodells (5), umfassend:

- einen Schritt (E10) zum Erfassen eines stabilen Zustandes von wenigstens einem ersten Parameter (T25) des Modells, wobei dieser erste Parameter für ein durch einen Sensor (3) geliefertes Signal repräsentativ ist,
- einen Schritt (E60) zum Erhalten eines Rückstellparameters (GainF) des Modells, während des stabilen Zustandes des ersten Parameters (T25) in Abhängigkeit von dem ersten Parameter, eines zweiten Parameters (PCN12R) des Modells, und des numerischen Grundmodells (5), und
- einen Schritt (E70) zum Erhalten eines rückgestellten Modells anhand des numerischen Grundmodells (5) und des Rückstellparameters (GainF).

**2.** Rückstellverfahren nach Anspruch 1, **dadurch gekennzeichnet, dass** es umfasst:

- einen vorbereitenden Schritt (E5) zum Partitionieren des Bereiches der möglichen Werte des zweiten Parameters (PCN12R) in eine Vielzahl von Bereichen,
- einen Schritt (E30) zum Bestimmen und zum Speichern des Bereiches, in dem sich der zweite Parameter (PCN12R) während des stabilisierten Zustandes des ersten Parameters (T25) befindet,
- einen Schritt (E20) zum Berechnen oder zum Schätzen (E25) eines lokalen Rückstellwertes (KREC) und zum Zuweisen (E40) des lokalen Wertes (Gain1, Gain2, Gain3) zu wenigstens einem der Bereiche (PL1, PL2, PL3),
- wobei der Rückstellparameter (GainF) anhand der lokalen Rückstellwerte (Gain1, Gain2, Gain3) und des aktuellen Wertes des zweiten Parameters (PCN12R) erhalten wird (E60).

3. Verfahren nach Anspruch 2, **dadurch gekennzeichnet, dass** der lokale Rückstellwert (Gain1), welcher einem der Bereiche (PL1) zugewiesen ist, ein Wert (Gain2) ist, der einem anderen der Bereiche (PL2) zugewiesen ist, wobei dieser andere Bereich anhand einer Wahrheitstabelle (40) bestimmt wird.

4. Verfahren nach Anspruch 2 oder 3, **dadurch gekennzeichnet, dass** es für wenigstens einen Teil des Wertebereichs einen Schritt (E50) zum Interpolieren des Rückstellparameters (Gain1to2) anhand wenigstens eines der lokalen Rückstellwerte (Gain1, Gain2) umfasst.

5. Rückstellverfahren nach einem der Ansprüche 2 bis 4, wobei das Verfahren in einem Turbostrahltriebwerk ein einziges Mal pro Flug durchgeführt wird, und **dadurch gekennzeichnet, dass** es nach der Bestimmung des Bereiches, in dem sich der zweite Parameter (PCN12R) befindet, einen Schritt zum Speichern des zweiten Parameters und des lokalen Rückstellwertes in einem dem Bereich zugeordneten nicht flüchtigen Speicher umfasst.

6. Rückstellverfahren nach Anspruch 5, bei dem:

   - das Modell ein Gewinn-Gesetz ist, welches das Verhältnis zwischen zwei Temperaturen (T25, T12) in zwei unterschiedlichen Stufen des Turbostrahltriebwerks in Abhängigkeit von einer Rotationsgeschwindigkeit (PCN12R) eines Gebläses des Turbostrahltriebwerks liefert,
   - wobei der erste Parameter (T25) eine der Temperaturen ist,
   - wobei der zweite Parameter die Rotationsgeschwindigkeit (PCN12R) ist.

7. Rückstellverfahren nach Anspruch 6, **dadurch gekennzeichnet, dass** es einen Schritt zum Berechnen eines korrigierten Wertes (T25REC) des ersten Parameters anhand des aktuellen Wertes des ersten Parameters (T25) und des rückgestellten Modells umfasst.

8. Rückstellverfahren nach einem der Ansprüche 5 bis 7, **dadurch gekennzeichnet, dass** der Schritt des Speicherns des Bereiches, in dem sich der zweite Parameter (PCN12R) befindet, unter der Bedingung des positiven Ergebnisses eines Schrittes (E25) zur Überprüfung des gestarteten Zustandes eines Motors des Turbostrahltriebwerks durchgeführt wird.

9. Rückstellverfahren nach einem der Ansprüche 5 bis 8, **dadurch gekennzeichnet, dass** es einen Schritt zum Glätten des Rückstellparameters (GainF) umfasst.

10. System zur Rückstellung (1) eines numerischen Grundmodells (5), umfassend:

   - ein Modul (10) zum Erfassen eines stabilen Zustandes von wenigstens einem ersten Parameter (T25) des Modells, wobei dieser erste Parameter für ein durch einen Sensor (3) geliefertes Signal repräsentativ ist,
   - ein Modul (70) zum Erhalten eines Rückstellparameters (KREC) des Modells, während des stabilen Zustandes des ersten Parameters (T25) in Abhängigkeit von dem ersten Parameter, eines zweiten Parameters (PCN12R) des Modells, und des numerischen Grundmodells (5), und
   - ein Modul (80) zum Erhalten eines rückgestellten Modells anhand des numerischen Grundmodells (5) und des Rückstellparameters (GainF).

11. Turbostrahltriebwerk, **dadurch gekennzeichnet, dass** es ein System zur Rückstellung eines numerischen Grundmodells nach Anspruch 10 umfasst.

12. Verwendung eines Rückstellverfahrens nach einem der Ansprüche 5 bis 9, bei dem für die Regulierung des Turbostrahltriebwerks der erste Parameter (T25REC) des rückgestellten Modells anstelle des ersten Parameters (T25), welcher für das durch den Sensor (3) gelieferte Signal repräsentativ ist, verwendet wird, wobei dieses durch den Sensor gelieferte Signal nur verwendet wird, um das Grundmodell rückzustellen und um das rückgestellte Modell zu erhalten.

**Claims**

1. A method for recalibrating a digital basic model (5) including:

- a step (E10) for detecting a stable state of at least one first parameter (T25) of said model, this first parameter being representative of a signal delivered by a sensor (3);
- a step (E60) for obtaining a recalibration parameter (GainF) of said model, during said stable state of said first parameter (T25), as a function of the first parameter, a second parameter (PCN12R) of said model, and said digital basic model (5); and
- a step (E70) for obtaining a recalibrated model from the digital basic model (5) and the recalibration parameter (GainF).

2. The recalibration method according to claim 1, **characterized in that** it includes:

- a preliminary step (E5) for partitioning of the set of possible values of said second parameter (PCN12R) into a plurality of ranges;
- a step (E30) for determining and storing the range in which the second parameter (PCN12R) is found during the stabilized state of the first parameter (T25);
- a step (E20) for calculating or estimating (E25) a local recalibration value (KREC) and assigning (E40) said local value (Gain1, Gain2, Gain3) to at least one of said ranges (PL1, PL2, PL3);
- said recalibration parameter (GainF) being obtained (E60) from said local recalibration values (Gain1, Gain2, Gain3) and the current value of said second parameter (PCN12R).

3. The method according to claim 2, **characterized in that** said local recalibration value (Gain1) assigned to one of said ranges (PL1) is a value (Gain2) assigned to another of said ranges (PL2), this other range being determined from a truth table (40).

4. The method according to claim 2 or 3, **characterized in that** it includes, for at least part of said set of values, a step (E50) for intercalating said first recalibration value (Gainlto2) from at least one of said local recalibration values (Gain1, Gain2).

5. The recalibration method according to any one of claims 2 to 4, said method being implemented in a turbojet engine once and only once per flight, and **characterized in that** it includes, after said determination of the range in which the second parameter (PCN12R) is found, a step for storing, in a nonvolatile memory associated with said range, said second parameter and said local recalibration value.

6. The recalibration method according to claim 5, wherein:

- said model is a gain law giving the ratio between two temperatures (T25, T12) at two different stages of the turbojet engine as a function of a rotation speed (PCN12R) of a fan of said turbojet engine;
- said first parameter (T25) being one of said temperatures;
- said second parameter being said rotation speed (PCN12R).

7. The recalibration method according to claim 6, **characterized in that** it includes a step for calculating a corrected value (T25REC) of said first parameter from the current value of the first parameter (T25) and the recalibrated model.

8. The recalibration method according to any one of claims 5 to 7, **characterized in that** said step for storing the range in which the second parameter (PCN12R) is found is done on the conditions of obtaining a positive result of a step (E25) for verifying the started state of a motor of the turbojet engine.

9. The recalibration method according to any one of claims 5 to 8, **characterized in that** it includes a step for smoothing the recalibration parameter (GainF).

10. A system (1) for recalibrating a digital basic model (5) including:

- a module (10) for detecting a stable state of at least a first parameter (T25) of said model, this first parameter being representative of a signal delivered by a sensor (3);
- a module (70) for obtaining a recalibration parameter (KREC) of said model, during said stable state of said first parameter (T25), as a function of said first parameter, a second parameter (PCN12R) of said model, and said digital basic model (5); and
- a module (80) for obtaining a recalibrated model from the digital basic model (5) and the recalibration parameter (GainF).

**11.** A turbojet engine, **characterized in that** it includes a system for recalibrating a digital basic model according to claim 10.

**12.** A use of a recalibration method according to any one of claims 5 to 9, wherein one uses, to regulate said turbojet engine, said first parameter (T25REC) of the recalibrated model, in place of the first parameter (T25) representative of the signal delivered by the sensor (3), this signal delivered by said sensor only being used to recalibrate said basic model and obtain said recalibrated model.

FIG.1

FIG.2

EP 3 011 399 B1

| PARTITIONNEMENT | E5 |

| PREMIER PARAMETRE (T25) STABLE | E10 |

| CALCUL D'UNE VALEUR PROVISOIRE DE RECALAGE | E20 |

| DETERMINATION DE LA PLAGE DEUXIEME PARAMETRE (PCN12R) | E30 |

| MEMORISATION VALEURS PROVISOIRES DE RECALAGE (GAIN i) ET DEUXIEMES PARAMETRES (PCN12Ri) | E40 |

| INTERPOLATION | E50 |

| OBTENTION DU PARAMETRE DE RECALAGE | E60 |

| RECALAGE MODELE | E70 |

FIG.3

FIG.4

FIG.5

| Num | e1 | e2 | e3 | s1 | s2 | s3 |
|-----|----|----|----|----|----|----|
| 1 | 0 | 0 | 0 | 0 | 0 | 0 |
| 2 | 0 | 0 | 1 | 3 | 3 | 3 |
| 3 | 0 | 1 | 0 | 2 | 2 | 2 |
| 4 | 0 | 1 | 1 | 2 | 2 | 3 |
| 5 | 0 | 0 | 0 | 1 | 1 | 1 |
| 6 | 0 | 0 | 1 | 1 | 3 | 3 |
| 7 | 0 | 1 | 0 | 1 | 2 | 2 |
| 8 | 0 | 1 | 1 | 1 | 2 | 3 |

40

## FIG.6

FIG.8

FIG.7

FIG.9

**RÉFÉRENCES CITÉES DANS LA DESCRIPTION**

**Documents brevets cités dans la description**

- US 5080496 A
- WO 2010067009 A